# EUROPEAN PATENT APPLICATION

(11) **EP 4 401 523 A1**
(43) Date of publication of application: **17.07.2024**
(21) Application number: 24151485.0
(22) Date of filing: 11.01.2024
(51) Int. Cl.: H05K 7/20, H01L 23/427, H01L 23/46

(54) **SYSTEMS AND METHODS FOR TWO-PHASE COLD PLATE COOLING**

(30) Priority: 13.01.2023 US 202363479986 P
(71) Applicant: Vertiv Corporation, Westerville, OH 43082 (US)
(72) Inventor: SCHRADER, Timothy, Irwin, Ohio, 43029 (US); KING, Jeremy, Delaware, Ohio, 43015 (US); RATCLIFFE, Gregory, Delaware, Ohio, 43015 (US)
(74) Representative: Bryn-Jacobsen, Caelia

(57) **Abstract**

A cold plate can include a first end, a second end opposite the first end, and a plurality of channels therein. A first plurality of channels can run from the first end to the second end. A second plurality of channels can run from the second end to the first end. The first and second pluralities of channels can be interleaved. The cold plate can include first and second outlet ports of greater height and width than first and second inlet ports, and a third outlet port of greater height and width than a third inlet port. A third channel can be disposed at least partially between first and second channels.

## Description

### CROSS REFERENCE TO RELATED APPLICATIONS

This application claims the benefit of US Provisional Patent Application Number 63/479,986 filed January 13, 2023, the entire contents of which are hereby incorporated by reference herein.

### STATEMENT REGARDING FEDERALLY SPONSORED RESEARCH OR DEVELOPMENT

Not applicable.

### REFERENCE TO APPENDIX

Not applicable.

### BACKGROUND OF THE INVENTION

Field of the Invention. The present disclosure relates generally to cooling systems, such as for use with computer processors, and more specifically relates to refrigerant based cooling systems utilizing cold plates.

### Description of the Related Art.

Many industries use various types of electronic devices, such as computer servers and other electronic devices having electronic processors and sensors that generate heat during use. The electronic devices are frequently attached to racks capable of supporting the electronic devices and require the continuous removal of heat for proper operation. With the ongoing shrinkage of electronic devices, the use of air as a cooling medium has reached a limitation on how much heat can be reasonably removed with a reasonably attainable air stream. Accordingly, an improved cooling method employs direct conduction cooling from a cooling fluid, or refrigerant, flowing within one or more heat sinks used in this field, generally known as "cold plates," that contact either the components themselves or the heat rejection plate of a secondary cooling loop in contact with the components.

The cold plates require a sufficient flow of cooling fluid, or refrigerant, that can be significantly lower than flow rates previously encountered in air heat exchanger applications and even in other fluid-cooled applications. However, large pressure drops (such as can occur due to a change of phase from higher density liquid to lower density vapor) across such cold plates can require increased system pressures and temperatures, thereby decreasing overall system efficiency.

### BRIEF SUMMARY OF THE INVENTION

Applicants have created new and useful devices, systems and methods for refrigerant-based cooling systems utilizing cold plates. In at least one embodiment, a cooling system can utilize a cold plate to cool a computer processor, or other heat source, and a compressor and/or pump (and/or heat exchanger) to pump a refrigerant through the cold plate, where the refrigerant changes from liquid to vapor, absorbing heat from the processor. In at least one embodiment, the cold plate can have a top, a bottom, a first end, a second end opposite the first end, and a plurality of channels therein. In at least one embodiment, the cold plate can include first and second inlet ports positioned along the first end. In at least one embodiment, the cold plate can include a third inlet port positioned along the second end. The inlet ports can be adjacent to the bottom of the cold plate.

In at least one embodiment, the cold plate can include first and second outlet ports positioned along the second end. In at least one embodiment, the cold plate can include a third outlet port positioned along the first end. The outlet ports can be adjacent to the top of the cold plate. The outlet ports can be of greater height and width than the inlet ports.

The cold plate can further include a plurality of channels running between respective ones of the inlet and outlet ports. For example, cold plate can include a first channel running between the first inlet port and the first outlet port, a second channel running between the second inlet port and the second outlet port, and a third channel running between the third inlet port and the third outlet port. In at least one embodiment, the third channel can be located at least partially between the first and second channels. In at least one embodiment, the first and second channels can be identical and parallel. In at least one embodiment, the third channel can be identical but oppositely oriented to the first and/or second channels.

In at least one embodiment, the cold plate can be configured to receive refrigerant, in a liquid phase, into both first and second ends and transmit the refrigerant, in a vapor phase, from both first and second ends. For example, the first and second inlet ports can be fluidically coupled by a first manifold, such as adjacent to the bottom of the first end of the cold plate, and the first and second outlet ports can be fluidically coupled by a second manifold, such as adjacent to the top of the second end of the cold plate. Similarly, the third inlet port can be fluidically coupled to a third manifold, such as adjacent to the bottom of the second end of the cold plate below the second manifold, and the third outlet port can be fluidically coupled to a fourth manifold, such adjacent to the top of the first end of the cold plate above the first manifold.

Thus, in at least one embodiment, the cold plate can have some channels flowing refrigerant from the first end to the second end and other channels flowing refrigerant from the second end to the first end. Such a configuration may maximize thermal transfer by providing a more uniform thermal transfer.

In at least one embodiment, the cold plate can have a different number of channels flowing refrigerant from the first end to the second end as compared to the number of channels flowing refrigerant from the second end to the first end. In at least one embodiment, the cold plate can have the same number of channels flowing refrigerant from the first end to the second end and as channels flowing refrigerant from the second end to the first end. For example, the cold plate can include a fourth inlet port positioned along the second end adjacent to the bottom, a fourth outlet port positioned along the first end adjacent to the top, and a fourth channel running between the fourth inlet port and the fourth outlet port. The fourth channel can be identical and/or parallel to the third channel. The fourth channel can be located adjacent to the first or second channel.

In at least one embodiment, one or more channels can be configured to minimize pressure drop of a refrigerant as the refrigerant changes phase from liquid to vapor flowing from the inlet ports to the outlet ports. In at least one embodiment, one or more channels can have an internal cross-sectional area or flow area larger than that of one or more inlet ports and/or outlet ports.

In at least one embodiment, one cold plate of one cooling system can be coupled with another cold plate of another cooling system, such as to provide at least some cooling even if one cooling system malfunctions, or is shut down (such as when maximum cooling is not required). For example, the inlet ports of one cold plate can be connected to the outlet ports of another cold plate.

In at least one embodiment, the cooling fluid provided to the inlet manifolds on both ends of the cold plate can come from the same cooling circuit and/or the fluid leaving the outlet manifolds on both ends can return to the same cooling circuit. In at least one embodiment, the cooling fluid provided to the inlet manifold on the first end of the cold plate can come from a first cooling circuit, with the cooling fluid from the outlet ports on the second end of the cold plate returning to the first cooling circuit, and/or the cooling fluid into the inlet manifold on the second end of the cold plate can come from a second cooling circuit, with the cooling fluid from the outlet ports on the first end of the cold plate returning to the second cooling circuit. In this manner, these and other embodiments can be adapted for providing redundancy at one or more cold plates, e.g., if one or more heat exchange circuits are not functioning normally or are offline for one reason or another.

In at least one embodiment, two or more channels can be substantially uniform and/or parallel. In at least one embodiment, two or more channels can be non-uniform and/or not parallel. In at least one embodiment, each channel can be designed and arranged for directing refrigerant flow in order to manage hot spots or otherwise optimize cooling in accordance with an implementation of the disclosure, which can include optimizing cooling for uniquely or irregularly shaped heat sources. For example, one or more cold plates can be designed and arranged to optimize cooling for a specific processor or arrangement of processor(s) (or other heat source(s), as the case may be), and each channel can be designed and arranged for directing or routing refrigerant flow to best manage heat exchange for one or more implementation-specific hot spots, such as one or more hot spots or other areas in need of cooling identified by way of a heat map, thermal CAD analysis, or other assessment for mapping heat transfer needs in accordance with one or more heat sources at hand.

In at least one embodiment, a cold plate according to the disclosure can have a top, a bottom, a first end, a second end opposite the first end, and a plurality of channels therein. In at least one embodiment, the cold plate can include first and second inlet ports positioned along the first end, a third inlet port positioned along the second end, first and second outlet ports positioned along the second end, a third outlet port positioned along the first end, a first channel running between the first inlet port and the first outlet port; a second channel running between the second inlet port and the second outlet port, a third channel running between the third inlet port and the third outlet port, the third channel located between the first and second channels, or any combination thereof. In at least one embodiment, any or all of the outlet ports can have a greater cross sectional area than any or all of the inlet ports. In at least one embodiment, a first channel wall, between the first channel and the third channel, can be thicker than a second channel wall, between the second channel and the third channel.

In at least one embodiment, the cold plate can include a fourth channel running between a fourth inlet port, positioned along the second end, and a fourth outlet port, positioned along the first end. In at least one embodiment, the fourth channel can be located adjacent the second channel. In at least one embodiment, a third channel wall, between the second channel and the fourth channel can be thicker than the second channel wall. In at least one embodiment, the third channel wall, between the second channel and the fourth channel can be thinner than the second channel wall.

In at least one embodiment, the first and second channels can be identical and/or parallel. In at least one embodiment, the third channel can be identical, but oppositely oriented, to the first channel and/or the second channel. In at least one embodiment, the cold plate can receive refrigerant, in a liquid phase, into both the first and second ends and can transmit the refrigerant, in a vapor phase, from both the first and second ends.

In at least one embodiment, the first and second inlet ports can be fluidically coupled by a first manifold adjacent to the first end of the cold plate and/or the first and second outlet ports can be fluidically coupled by a second manifold adjacent to the second end of the cold plate. In at least one embodiment, the third inlet port can be fluidically coupled to a third manifold adjacent to the second end of the cold plate, meshed with the second manifold, and/or the third outlet port can be fluidically coupled to a fourth manifold adjacent to the first end of the cold plate, meshed with the first manifold.

### BRIEF DESCRIPTION OF THE SEVERAL VIEWS OF THE DRAWINGS

FIG. 1 is a schematic diagram of one of many embodiments of a cooling system according to the disclosure.
FIG. 2 is a cross sectional elevation view of one of many embodiments of a cold plate, showing a channel flowing right to left according to the disclosure.
FIG. 3 is a cross sectional elevation view of one of many embodiments of a cold plate, showing a channel flowing left to right according to the disclosure.
FIG. 4 is an end elevation view of one of many embodiments of a cold plate according to the disclosure.
FIG. 5 is a cross sectional plan view of one of many embodiments of a cold plate, showing multiple channels flowing right to left and left to right according to the disclosure.
FIG. 6 is a cross sectional plan view of another one of many embodiments of a cold plate, showing multiple channels flowing right to left and left to right according to the disclosure.
FIG. 7 is a cross sectional plan view of the cold plate of FIG. 6, showing inlet and outlet manifolds.
FIG. 8 is a perspective view of the cold plate of FIG. 6.
FIG. 9 is an end elevation view of the cold plate of FIG. 6, showing a heat load contour.
FIG. 10 is a side elevation view of the cold plate of FIG. 6.
FIG. 11 is cross sectional elevation view of one of many embodiments of an outlet manifold for a cold plate according to the disclosure.
FIG. 12 is cross sectional elevation view of one of many embodiments of an inlet manifold for a cold plate according to the disclosure.
FIG. 13 is cross sectional elevation view of one of many embodiments of inlet and outlet manifolds, shown meshed for use with a cold plate according to the disclosure.

### DETAILED DESCRIPTION OF THE INVENTION

The Figures described above and the written description of specific structures and functions below are not presented to limit the scope of what Applicants have invented or the scope of the appended claims. Rather, the Figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with systemrelated, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the Figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Process flowcharts discussed herein illustrate the operation of possible implementations of systems, methods, and computer program products according to various embodiments of the present invention. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicants have created new and useful devices, systems and methods for refrigerant based cooling systems utilizing cold plates. Embodiments of the disclosure can help maximize thermal transfer by providing a more uniform thermal transfer versus conventional devices. Embodiments of the disclosure can help minimize pressure drop of a refrigerant as the refrigerant changes phase from liquid to vapor flowing from the inlet ports to the outlet ports. In at least one embodiment, a cold plate can include first and second inlet ports positioned along a first end and a plurality of channels. The cold plate can include a third inlet port positioned along a second end and first and second outlet ports positioned along the second end. A third outlet port can be positioned along the first end. The outlet ports can be of greater height and width than the inlet ports. The plurality of channels can run between respective ones of the inlet and outlet ports. For example, a first channel can run between the first inlet port and the first outlet port, a second channel can run between the second inlet port and the second outlet port, and a third channel can run between the third inlet port and the third outlet port. In at least one embodiment, the third channel can be located at least partially between the first and second channels. In at least one embodiment, the first and second channels can be identical and parallel to one another. In at least one embodiment, the third channel can be identical but oppositely oriented to the first and/or second channels. In at least one embodiment, the channels can each have an internal cross-sectional area or flow area larger than that of the inlet ports and/or the outlet ports.

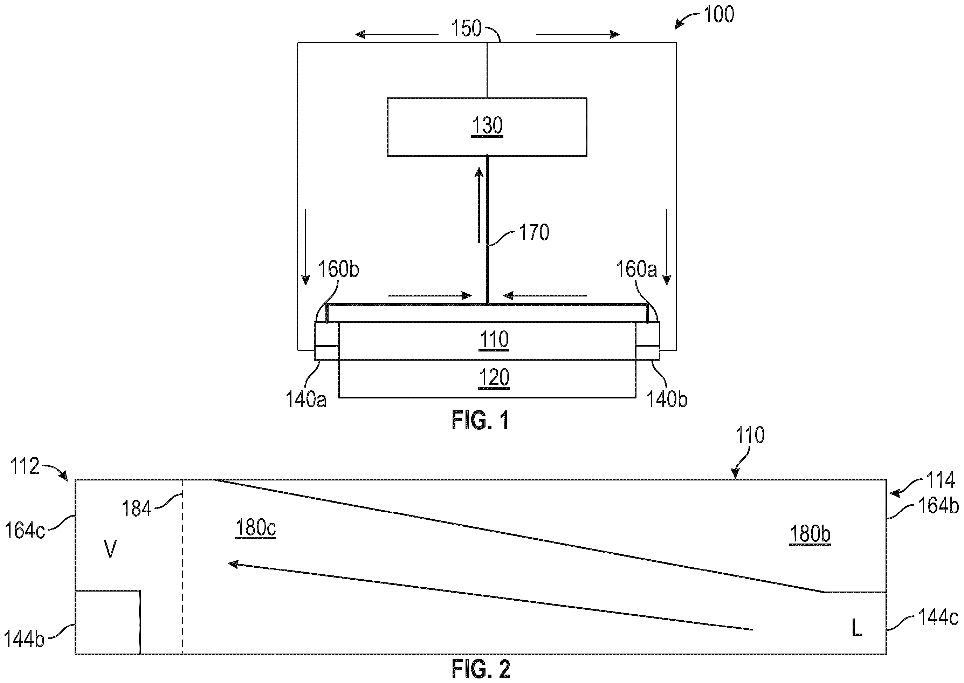

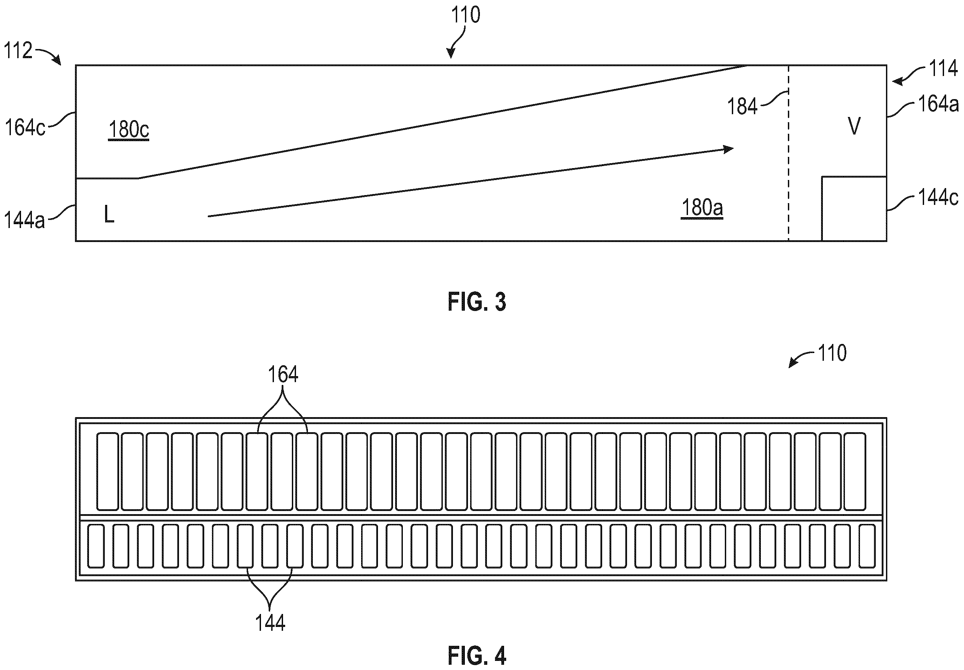

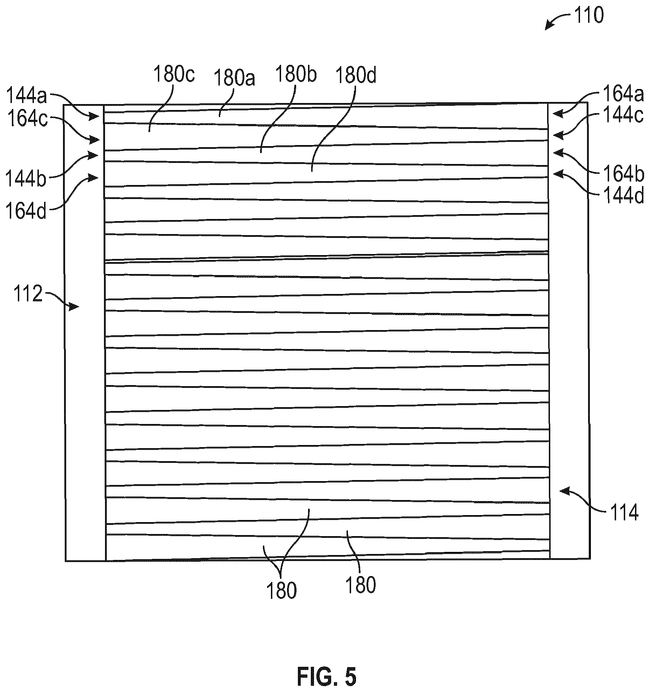

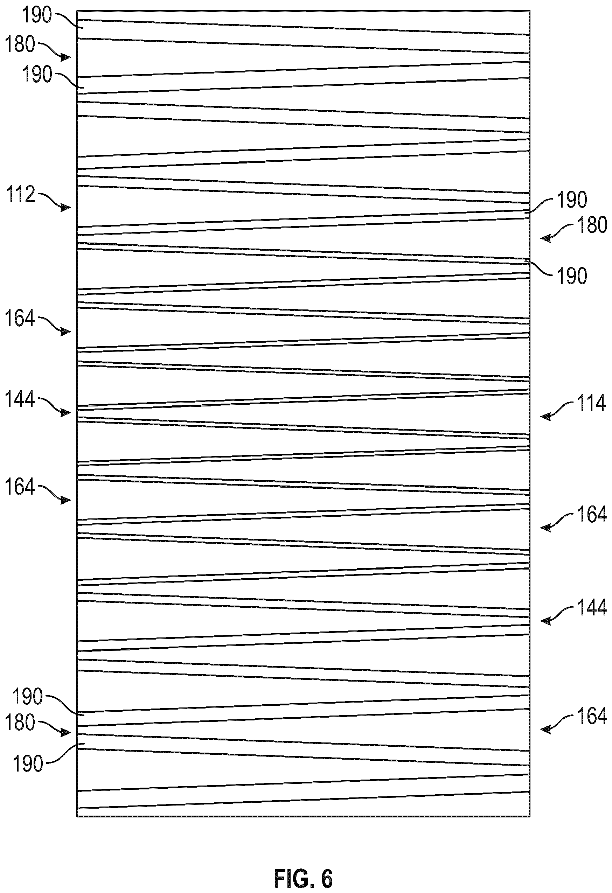

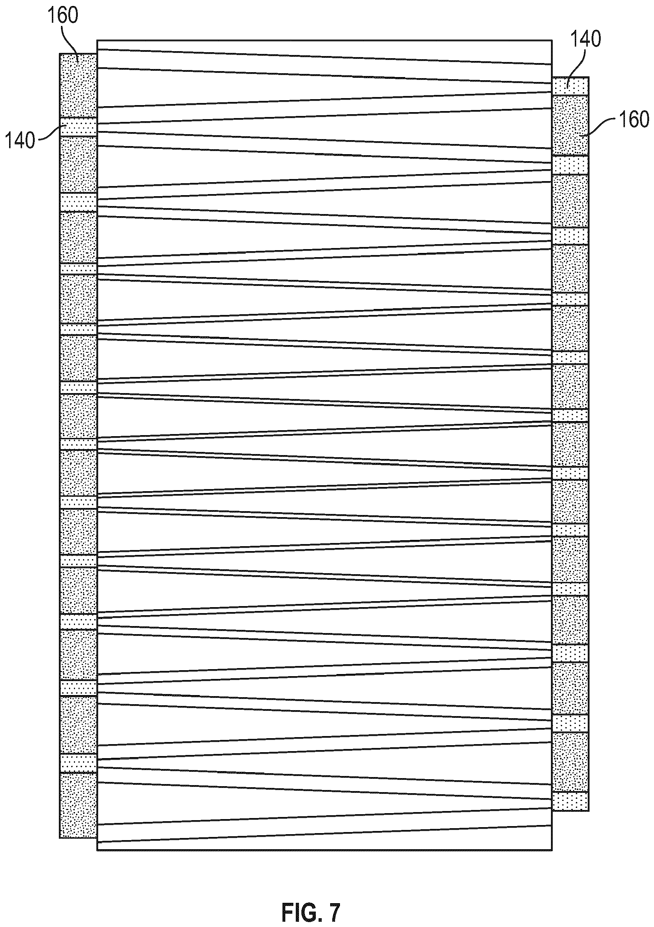

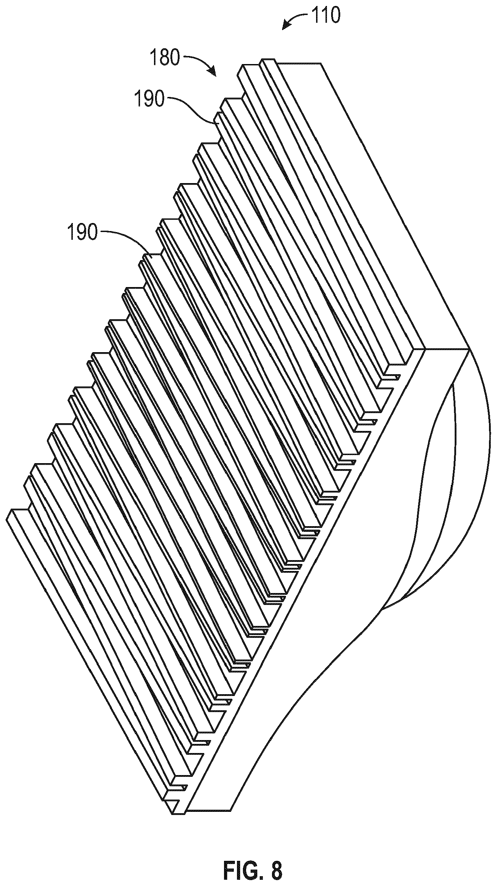

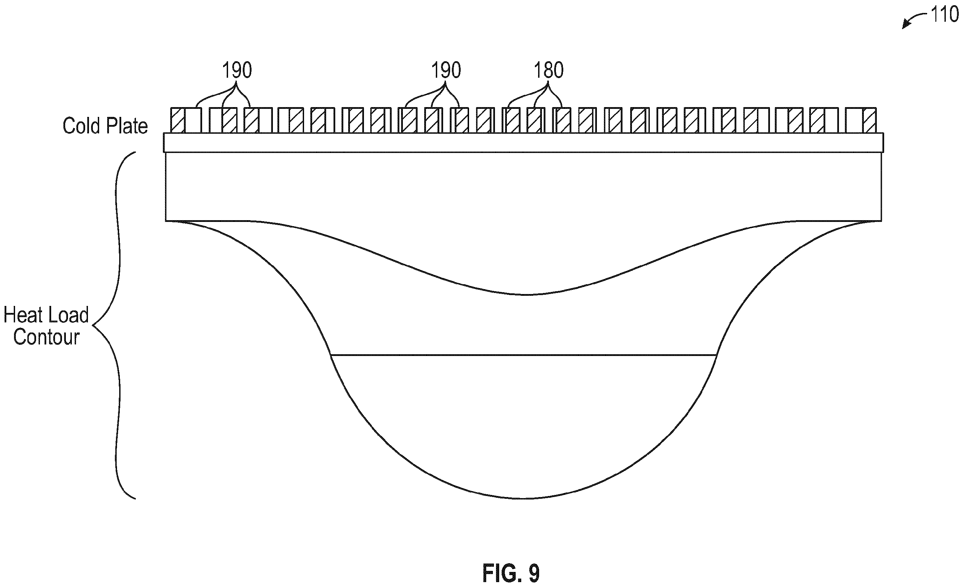

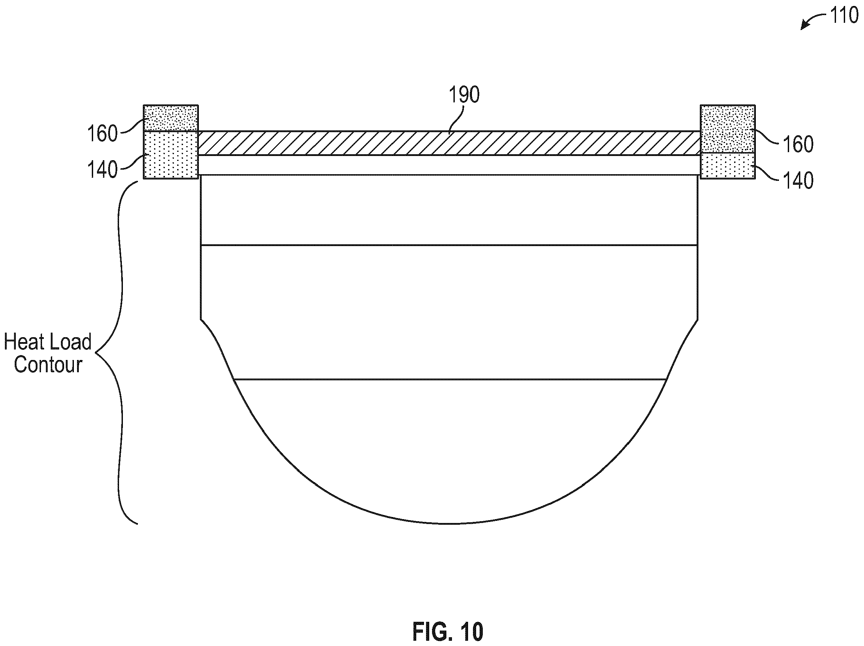

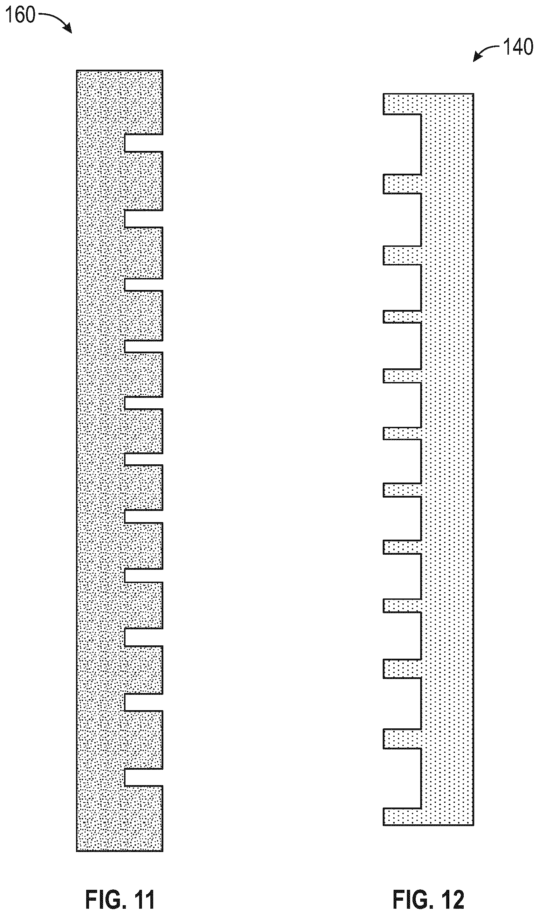

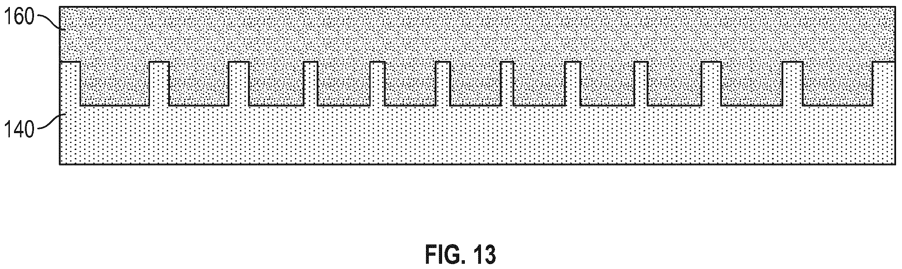

FIG. 1 is a schematic diagram of one of many embodiments of a cooling system according to the disclosure. FIG. 2 is a cross sectional elevation view of one of many embodiments of a cold plate, showing a channel flowing right to left according to the disclosure. FIG. 3 is a cross sectional elevation view of one of many embodiments of a cold plate, showing a channel flowing left to right according to the disclosure. FIG. 4 is an end elevation view of one of many embodiments of a cold plate according to the disclosure. FIG. 5 is a cross sectional plan view of one of many embodiments of a cold plate, showing multiple channels flowing right to left and left to right according to the disclosure. FIG. 6 is a cross sectional plan view of another one of many embodiments of a cold plate, showing multiple channels flowing right to left and left to right according to the disclosure. FIG. 7 is a cross sectional plan view of the cold plate of FIG. 6, showing inlet and outlet manifolds. FIG. 8 is a perspective view of the cold plate of FIG. 6. FIG. 9 is an end elevation view of the cold plate of FIG. 6, showing a heat load contour. FIG. 10 is a side elevation view of the cold plate of FIG. 6. FIG. 11 is cross sectional elevation view of one of many embodiments of an outlet manifold for a cold plate according to the disclosure. FIG. 12 is cross sectional elevation view of one of many embodiments of an inlet manifold for a cold plate according to the disclosure. FIG. 13 is cross sectional elevation view of one of many embodiments of inlet and outlet manifolds, shown meshed for use with a cold plate according to the disclosure. FIGS. 1-13 are described in conjunction with one another.

In at least one embodiment, a cooling system 100 can utilize a cold plate 110 to cool a computer processor 120, or other heat source, and a compressor and/or pump 130 (and/or heat exchanger) to pump a refrigerant through the cold plate 110, where the refrigerant changes from liquid to vapor, absorbing heat from the processor 120. In at least one embodiment, the refrigerant flows to the cold plate 110 in liquid form through inlet lines 150. In at least one embodiment, the refrigerant flows from the cold plate 110 in vapor form through outlet lines 170.

In at least one embodiment, the cold plate 110 can have a top, a bottom, a first end 112, a second end 114 opposite the first end 112, and a plurality of channels 180 therein. In at least one embodiment, the cold plate 110 can include a plurality of inlet ports 144 positioned along the first end 112 and a plurality of outlet ports 164 positioned along the second end 114. In at least one embodiment, the inlet ports 144 can be adjacent to the bottom of the cold plate 110 and/or the outlet ports 164 can be adjacent to the top of the cold plate 110, but other configurations are envisioned. In at least one embodiment, the outlet ports 164 can be of greater height and width, and therefore have a greater cross-sectional area, than the inlet ports 144.

In at least one embodiment, the cold plate 110 can include first and second inlet ports 144a, 144b positioned along the first end 112. In at least one embodiment, the cold plate 110 can include first and second outlet ports 164a, 164b positioned along the second end 114. In at least one embodiment, the cold plate 110 can include a third inlet port 144c positioned along the second end 114. In at least one embodiment, the cold plate 110 can include a third outlet port 164c positioned along the first end 112.

The cold plate 110 can further include a plurality of channels 180 running between respective ones of the inlet and outlet ports 144, 164. For example, cold plate 110 can include a first channel 180a running between the first inlet port 144a and the first outlet port 164a, a second channel 180b between the second inlet port 144b and the second outlet port 164b, and a third channel 180c running between the third inlet port 144c and the third outlet port 164c. In at least one embodiment, the third channel 180c can be located at least partially between the first and second channels 180a, 180b. In at least one embodiment, the first and second channels 180a, 180b can be identical and parallel. In at least one embodiment, the third channel 180c can be identical but oppositely oriented to the first and/or second channels 180a, 180b.

In at least one embodiment, the cold plate 110 can be configured to receive refrigerant, in a liquid phase, into both first and second ends 112, 114 and transmit the refrigerant, in a vapor phase, from both first and second ends 112, 114. For example, the first and second inlet ports 144a, 144b can be fluidically coupled by a first inlet manifold 140a, such as adjacent to the bottom of the first end 112 of the cold plate 110. Similarly, the first and second outlet ports 164a, 164b can be fluidically coupled by a first outlet manifold 160a, such as adjacent to the top of the second end 114 of the cold plate 110. In at least one embodiment, the third inlet port 144c can be fluidically coupled to a second inlet manifold 140b, such as adjacent to the bottom of the second end 112 the cold plate 110 below the second manifold first outlet manifold 160a, and the third outlet port 164c can be fluidically coupled to a second outlet manifold 160b, such adjacent to the top of the first end 112 of the cold plate 110 above the first inlet manifold 140a.

Thus, in at least one embodiment, the cold plate 110 can have some channels 180 flowing refrigerant from the first end 112 to the second end 114 and other channels 180 flowing refrigerant from the second end 114 to the first end 112. Such a configuration may maximize thermal transfer by providing a more uniform thermal transfer. For example, it can be seen that refrigerant enters the cold plate, in liquid form, at both the first end 112 and the second end 114. As the refrigerant absorbs heat from the heat source 120, the refrigerant at least partially changes phase to vapor, or gas, and exits both the first end 112 and the second end 114 of the cold plate 110.

In at least one embodiment, the cold plate 110 have a different number of channels 180 flowing refrigerant from the first end 112 to the second end 114 and as compared to the number of channels 180 flowing refrigerant from the second end 114 the first end 112. In at least one embodiment, the cold plate 110 can have the same number of channels 180 flowing refrigerant from the first end 112 to the second end 114 as channels 180 flowing refrigerant from the second end 114 to the first end 112. For example, the cold plate 110 can include a fourth inlet port 144d positioned along the second end 114 adjacent to the bottom; a fourth outlet port 164d positioned along the first end 112 adjacent to the top; and a fourth channel 180d running between the fourth inlet port 144d and the fourth outlet port 164d. In at least one embodiment, the fourth channel 180d be identical and/or parallel to the third channel 180c. In at least one embodiment, the fourth channel 180d can be located adjacent to the first or second channel 180a, 180b.

In at least one embodiment, the channels 180 can be configured to minimize pressure drop of a refrigerant as the refrigerant changes phase from liquid to vapor flowing from the inlet ports 144 to the outlet ports 164, which can be larger than the inlet ports 144. Minimizing pressure drop can also minimize the overall system temperature approach and result in more efficient cooling. In at least one embodiment, the channels 180 can each have an internal expansion chamber. For example, the channels 180 can each have an internal cross-sectional area 184 larger than the inlet ports 144 and/or the outlet ports 164.

As shown in FIG. 3, which presents one of many possible embodiments, refrigerant enters the first inlet port 144a at the first end 112 of the cold plate 110, in liquid form. As the refrigerant moves from left to right in the first channel 180a it at least partially changes from liquid to vapor phase, absorbing heat from the heat source 120. The refrigerant then exits the cold plate through the outlet port 164a. It can be seen that the outlet port 164a is larger than the inlet port 144a, which allows the refrigerant to change phase, while minimizing the pressure drop across the cold plate 110. It can also be seen that the internal expansion chamber, within the first channel 180a, can be larger than the outlet port 164a. In at least one embodiment, as shown in the depicted embodiment, the adjacent channel 180c, with its inlet port 144c and outlet port 164c, can occupy part of the same cross-section of the cold plate 110. For example, the third inlet port 144c can encroach upon the cross-section of the first outlet port 164a, causing the first outlet port 164a to be smaller in cross-sectional area than the internal expansion chamber of the first channel 180a. This can be used to, for example, help control the flow of refrigerant through the cold plate 110, such as to optimize heat absorption.

Similarly, as shown in FIG. 2, which presents one of many possible embodiments, refrigerant enters the third inlet port 144c at the second end 114 of the cold plate 110, in liquid form. As the refrigerant moves from right to left in the third channel 180c it at least partially changes from liquid to vapor phase, absorbing heat from the heat source 120. The refrigerant then exits the cold plate through the outlet port 164c. It can be seen that the outlet port 164c is larger than the inlet port 144c, which allows the refrigerant to change phase, while minimizing the pressure drop across the cold plate 110. It can also be seen that the internal expansion chamber, within the third channel 180c, can be larger than the outlet port 164c. In at least one embodiment, as shown in the depicted embodiment, the adjacent channel 180b, with its inlet port 144b and outlet port 164b, can occupy part of the same cross-section of the cold plate 110. For example, the second inlet port 144b can encroach upon the cross-section of the third outlet port 164c, causing the third outlet port 164c to be smaller in cross-sectional area than the internal expansion chamber of the third channel 180c. This can be used to, for example, help control the flow of refrigerant through the cold plate 110, such as to optimize heat absorption.

In both the embodiments pictured in FIGS. 2 and 3, the internal expansion chamber of the channels 180a, 180c can have a cross-sectional area 184 larger than the respective outlet ports 164a, 164c. In at least one embodiment, the shape of the channels 180 maximizes liquid refrigerant contact at the bottom thereof, while allowing more space for the vapor refrigerant to escape from the outlet ports 164. In at least one embodiment, with additive manufacturing for example, the shapes of the channels (and/or their walls) can be non-uniform and/or non-linear in any direction. In at least one embodiment, the channels 180a, 180c can be designed to maximize heat transfer while minimizing pressure drop in the direction of flow due to the lower density vapor as the refrigerant changes phase.

As shown in FIG. 4, which presents one of many possible embodiments, refrigerant enters the inlet ports 144 at one end of the cold plate 110, adjacent to the bottom thereby ensuring good heat absorption from the heat source 120, and exits the cold plate 110 through the outlet ports 164, adjacent to the top of the cold plate 110. In one embodiment, the channels 180 can be interleaved with alternating (or adjacent) ones of the channels flowing in opposite directions, which can provide improved distribution of two-phase cooling while minimizing refrigerant pressure, pressure drop, velocity, or any combination thereof.

The cold plate 110 can be manufactured in a number of ways that can remove or minimize design constraints in shaping the channels 180 and/or portions thereof, such as the internal expansion chambers. In one embodiment, the cold plate 110 can be manufactured using three-dimensional printing, such as three-dimensional metal printing. In one embodiment, the cold plate 110 can be manufactured using laminated thin sheet stacking. In any case, the cold plate 110 can be manufactured such that the size, shape, dimensions, or any combination thereof, of the channels 180 can be varied in the direction of flow. For example, the cold plate 110 can be manufactured such that the size, shape, dimensions, or any combination thereof, of the channels 180 can be expanded in the direction of flow. In at least one embodiment, the cold plate 110 can be manufactured such that any of the dimensions of the channels 180 can diverge, or grow, in the direction of flow. In at least one embodiment, the cold plate 110 can be manufactured such that the velocity of the refrigerant is minimized through the cold plate 110, such as by minimizing the pressure drop across the cold plate 110, thereby minimizing the overall system temperature approach and maximizing cooling efficiency.

In at least one embodiment, one cold plate 110 of one cooling system 100 can be coupled with another cold plate 110 of another cooling system 100, such as to provide at least some cooling even if one cooling system 100 malfunctions, or is shut down (such as when maximum cooling is not required). For example, the inlet ports 144 of one cold plate 110 can be connected to the outlet ports of another cold plate 110.

In at least one embodiment, the cooling fluid provided to the inlet manifolds 140a, 140b on both ends of the cold plate 110 can come from the same cooling circuit and/or the fluid leaving the outlet manifolds 160a,160b on both ends can return to the same cooling circuit. In at least one embodiment, the cooling fluid provided to the inlet manifold 140a on the first end 112 of the cold plate 110 can come from a first cooling circuit, with the cooling fluid from the outlet manifold 160a on the second end 114 of the cold plate 110 returning to the first cooling circuit, and/or the cooling fluid into the inlet manifold 140b on the second end 114 of the cold plate 110 can come from a second cooling circuit, with the cooling fluid from the outlet manifold 160b on the first end 112 of the cold plate 110 returning to the second cooling circuit. These and other embodiments can provide redundancy at the one or more cold plates.

In at least one embodiment, the channels 180 can be substantially uniform and/or parallel. In at least one embodiment, the channels 180 can be non-uniform and/or not parallel. In at least one embodiment, each channel 180 can be designed to direct refrigerant flow to manage hots spots. For example, a cold plate 110 can be designed for a specific processor, or other heat source, and one or more channels 180 can be designed and arranged for directing refrigerant flow to one or more individual hots spots or other heat source areas, such as one or more heat-producing areas identified in a heat map, thermal model or similar thermal analysis.

As best shown in FIGS. 6-13, which presents one of many possible embodiments, the channels 180 of the cold plate 110 can be aligned next to each other and/or have the same height and/or elevation. In at least one embodiment, the inlet ports 144 can be aligned next to the outlet ports 164 and/or have the same height and/or elevation. In at least one embodiment, the inlet manifolds 140 and the outlet manifolds 160 can mesh together, with one or more portions of the inlet manifolds 140 meshing with one or more portions of the outlet manifolds 160. In at least one embodiment, one or more portions of the inlet manifolds 140 can extend below one or more portions of the outlet manifolds 160. In at least one embodiment, one or more portions of the inlet manifolds 140 can extend above one or more portions of the outlet manifolds 160.

In at least one embodiment, the inlet manifold 140 adjacent the first end 112 of the cold plate 110 can be identical to the inlet manifold 140 adjacent the second end 114 of the cold plate 110 and/or the outlet manifold 160 adjacent the first end 112 of the cold plate 110 can be identical to the outlet manifold 160 adjacent the second end 114 of the cold plate 110. In at least one embodiment, the inlet manifold 140 adjacent the first end 112 of the cold plate 110 can be different than the inlet manifold 140 adjacent the second end 114 of the cold plate 110 and/or the outlet manifold 160 adjacent the first end 112 of the cold plate 110 can be different than the outlet manifold 160 adjacent the second end 114 of the cold plate 110. For example, the inlet manifold 140 adjacent the first end 112 of the cold plate 110 can be designed to mesh with the outlet manifold 160 adjacent the first end 112 of the cold plate 110 but not the outlet manifold 160 adjacent the second end 114 of the cold plate 110 and/or the inlet manifold 140 adjacent the second end 114 of the cold plate 110 can be designed to mesh with the outlet manifold 160 adjacent the second end 114 of the cold plate 110 but not the outlet manifold 160 adjacent the first end 112 of the cold plate 110.

In at least one embodiment, one or more channel walls 190 between the channels 180 can be substantially uniform along their length and/or with respect to each other. In at least one embodiment, one or more channel walls 190 between the channels 180 can be non-uniform along their length and/or with respect to each other. In at least one embodiment, one or more channel walls 190 can be thicker adjacent the first end 112 of the cold plate 110 than the second end 114. In at least one embodiment, one or more channel walls 190 can be thinner adjacent the first end 112 of the cold plate 110 than the second end 114. In at least one embodiment, one or more channel walls 190 can be thicker than an adjacent channel wall 190. In at least one embodiment, one or more channel walls 190 can be thinner near a center of the cold plate 110, such as to provide more cooling near the center of the cold plate 110, than the channel walls 190 nearer to the sides of the cold plate 110. In at least one embodiment, one or more channel walls 190 can be thinner near one side of the cold plate 110, such as to provide more cooling near that side of the cold plate 110, than the channel walls 190 nearer to the opposite side of the cold plate 110.

In at least one embodiment, a cold plate 110 according to the disclosure can have a top, a bottom, a first end 112, a second end 114 opposite the first end 114, and a plurality of channels 180 therein. In at least one embodiment, the cold plate 110 can include first and second inlet ports 144 positioned along the first end 112, a third inlet port 144 positioned along the second end 114, first and second outlet ports 164 positioned along the second end 114, a third outlet port 164 positioned along the first end 112, a first channel 180 running between the first inlet port 144 and the first outlet port 164; a second channel 180 running between the second inlet port 144 and the second outlet port 164, a third channel 180 running between the third inlet port 144 and the third outlet port 164, the third channel 180 located between the first and second channels 180, or any combination thereof. In at least one embodiment, any or all of the outlet ports 164 can have a greater cross sectional area than any or all of the inlet ports 144. In at least one embodiment, a first channel wall 190, between the first and third channels 180, can be thicker than a second channel wall 190, between the second and third channels 180.

In at least one embodiment, the cold plate 110 can include a fourth channel 180 running between a fourth inlet port 144, positioned along the second end 114, and a fourth outlet port 164, positioned along the first end 112. In at least one embodiment, the fourth channel 180 can be located adjacent the second channel 180. In at least one embodiment, a third channel wall 190, between the second and fourth channels 180 can be thicker than the second channel wall 190. In at least one embodiment, the third channel wall 190, between the second and fourth channels 180 can be thinner than the second channel wall 190.

In at least one embodiment, the first and second channels 180 can be identical and/or parallel. In at least one embodiment, the third channel 180 can be identical, but oppositely oriented, to the first and/or second channel(s) 180. In at least one embodiment, the cold plate 110 can receive refrigerant, in a liquid phase, into both the first and second ends 112,114 and can transmit the refrigerant, in a vapor phase, from both the first and second ends 112,114.

In at least one embodiment, the first and second inlet ports 144 can be fluidically coupled by a first manifold 140 adjacent to the first end 112 of the cold plate 110 and/or the first and second outlet ports 164 can be fluidically coupled by a second manifold 160 adjacent to the second end 144 of the cold plate 110. In at least one embodiment, the third inlet port 144 can be fluidically coupled to a third manifold 140 adjacent to the second end 114 of the cold plate 110, meshed with the second manifold 160, and/or the third outlet port 164 can be fluidically coupled to a fourth manifold 160 adjacent to the first end 112 of the cold plate 110, meshed with the first manifold 140.

In at least one embodiment, a cooling system can utilize a cold plate to cool a computer processor, or other heat source, and a compressor and/or pump (and/or heat exchanger) to pump a refrigerant through the cold plate, where the refrigerant changes from liquid to vapor, absorbing heat from the processor. In at least one embodiment, the cold plate can have a top, a bottom, a first end, a second end opposite the first end, and a plurality of channels therein. In at least one embodiment, the cold plate can include first and second inlet ports positioned along the first end. In at least one embodiment, the cold plate can include a third inlet port positioned along the second end. The inlet ports can be adjacent to the bottom of the cold plate.

In at least one embodiment, the cold plate can include first and second outlet ports positioned along the second end. In at least one embodiment, the cold plate can include a third outlet port positioned along the first end. The outlet ports can be adjacent to the top of the cold plate. The outlet ports can be of greater height and width than the inlet ports.

The cold plate can further include a plurality of channels running between respective ones of the inlet and outlet ports. For example, cold plate can include a first channel running between the first inlet port and the first outlet port, a second channel running between the second inlet port and the second outlet port, and a third channel running between the third inlet port and the third outlet port. In at least one embodiment, the third channel can be located at least partially between the first and second channels. In at least one embodiment, the first and second channels can be identical and parallel. In at least one embodiment, the third channel can be identical but oppositely oriented to the first and/or second channels.

In at least one embodiment, the cold plate can be configured to receive refrigerant, in a liquid phase, into both first and second ends and transmit the refrigerant, in a vapor phase, from both first and second ends. For example, the first and second inlet ports can be fluidically coupled by a first manifold, such as adjacent to the bottom of the first end of the cold plate, and the first and second outlet ports can be fluidically coupled by a second manifold, such as adjacent to the top of the second end of the cold plate. Similarly, the third inlet port can be fluidically coupled to a third manifold, such as adjacent to the bottom of the second end of the cold plate below the second manifold, and the third outlet port can be fluidically coupled to a fourth manifold, such adjacent to the top of the first end of the cold plate above the first manifold.

Thus, in at least one embodiment, the cold plate can have some channels flowing refrigerant from the first end to the second end and other channels flowing refrigerant from the second end to the first end. Such a configuration may maximize thermal transfer by providing a more uniform thermal transfer.

In at least one embodiment, the cold plate can have a different number of channels flowing refrigerant from the first end to the second end and as compared to the number of channels flowing refrigerant from the second end to the first end. In at least one embodiment, the cold plate can have the same number of channels flowing refrigerant from the first end to the second end and as channels flowing refrigerant from the second end to the first end. For example, the cold plate can include a fourth inlet port positioned along the second end adjacent to the bottom; a fourth outlet port positioned along the first end adjacent to the top; and a fourth channel running between the fourth inlet port and the fourth outlet port. The fourth channel can be identical and/or parallel to the third channel. The fourth channel can be located adjacent to the first or second channel.

In at least one embodiment, the channels can be configured to minimize pressure drop of a refrigerant as the refrigerant changes phase from liquid to vapor flowing from the inlet ports to the outlet ports. In at least one embodiment, the channels can each have an internal cross-sectional area larger than the inlet ports and/or the outlet ports.

In at least one embodiment, one cold plate of one cooling system can be coupled with another cold plate of another cooling system, such as to provide at least some cooling even if one cooling system malfunctions, or is shut down (such as when maximum cooling is not required). For example, the inlet ports of one cold plate can be connected to the outlet ports of another cold plate.

In at least one embodiment, the cooling fluid provided to the inlet manifolds on both ends of the cold plate can come from the same cooling circuit and/or the fluid leaving the outlet manifolds on both ends can return to the same cooling circuit. In at least one embodiment, the cooling fluid provided to the inlet manifold on the first end of the cold plate can come from a first cooling circuit, with the cooling fluid from the outlet ports on the second end of the cold plate returning to the first cooling circuit, and/or the cooling fluid into the inlet manifold on the second end of the cold plate can come from a second cooling circuit, with the cooling fluid from the outlet ports on the first end of the cold plate returning to the second cooling circuit. These, and other, embodiment(s) provide redundancy at the one or more cold plates.

In at least one embodiment, the channels can be substantially uniform and/or parallel. In at least one embodiment, the channels can be non-uniform and/or not parallel. In at least one embodiment, each channel can be designed to direct refrigerant flow to manage hots spots. For example, a cold plate can be designed for a specific processor, or other heat source, with each channel designed direct refrigerant flow to individual hots spots, which can be identified in a heat map or similar analysis.

In at least one embodiment, a cold plate according to the disclosure can have a top, a bottom, a first end, a second end opposite the first end, and a plurality of channels therein. In at least one embodiment, the cold plate can include first and second inlet ports positioned along the first end, a third inlet port positioned along the second end, first and second outlet ports positioned along the second end, a third outlet port positioned along the first end, a first channel running between the first inlet port and the first outlet port; a second channel running between the second inlet port and the second outlet port, a third channel running between the third inlet port and the third outlet port, the third channel located between the first and second channels, or any combination thereof. In at least one embodiment, any or all of the outlet ports can have a greater cross sectional area than any or all of the inlet ports. In at least one embodiment, a first channel wall, between the first channel and the third channel, can be thicker than a second channel wall, between the second channel and the third channel.

In at least one embodiment, the cold plate can include a fourth channel running between a fourth inlet port, positioned along the second end, and a fourth outlet port, positioned along the first end. In at least one embodiment, the fourth channel can be located adjacent the second channel. In at least one embodiment, a third channel wall, between the second channel and the fourth channel can be thicker than the second channel wall. In at least one embodiment, the third channel wall, between the second channel and the fourth channel can be thinner than the second channel wall.

In at least one embodiment, the first and second channels can be identical and/or parallel. In at least one embodiment, the third channel can be identical, but oppositely oriented, to the first channel and/or the second channel. In at least one embodiment, the cold plate can receive refrigerant, in a liquid phase, into both the first and second ends and can transmit the refrigerant, in a vapor phase, from both the first and second ends.

In at least one embodiment, the first and second inlet ports can be fluidically coupled by a first manifold adjacent to the first end of the cold plate and/or the first and second outlet ports can be fluidically coupled by a second manifold adjacent to the second end of the cold plate. In at least one embodiment, the third inlet port can be fluidically coupled to a third manifold adjacent to the second end of the cold plate, meshed with the second manifold, and/or the third outlet port can be fluidically coupled to a fourth manifold adjacent to the first end of the cold plate, meshed with the first manifold.

Other and further embodiments utilizing one or more aspects of the disclosure can be devised without departing from the spirit of Applicants' disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicants, but rather, in conformity with the patent laws, Applicants intend to fully protect all such modifications and improvements that come within the scope or range of equivalents of the following claims.

## Claims

1. A cold plate having a top, a bottom, a first end, a second end opposite the first end, and a plurality of channels therein, the cold plate comprising:
first and second inlet ports positioned along the first end;
a third inlet port positioned along the second end;
first and second outlet ports positioned along the second end, wherein the first and second outlet ports are of greater height and width than the first and second inlet ports;
a third outlet port positioned along the first end, wherein the third outlet port is of greater height and width than the third inlet port;
a first channel running between the first inlet port and the first outlet port;
a second channel running between the second inlet port and the second outlet port; and
a third channel running between the third inlet port and the third outlet port, the third channel located at least partially between the first and second channels.

2. The cold plate of claim 1, wherein the first and second inlet ports are positioned along the first end adjacent to the bottom,
the third inlet port is positioned along the second end adjacent to the bottom,
the first and second outlet ports are positioned along the second end adjacent to the top,
the third outlet port is positioned along the first end adjacent to the top, and
the third channel is located between the first and second channels.

3. The cold plate of claim 1 or claim 2, wherein the first and second outlet ports are of greater cross sectional area than the first and second inlet ports;
wherein the third outlet port is of greater cross sectional area than the third inlet port; and
wherein a first channel wall, between the first channel and the third channel, is thicker than a second channel wall, between the second channel and the third channel.

4. The cold plate of any one of claims 1-3, wherein the channels each have an internal cross-sectional area larger than the inlet ports.

5. The cold plate of any one of claims 1-4, wherein the channels each have an internal cross-sectional area larger than the outlet ports.

6. The cold plate of any one of claims 1-5, wherein the first and second channels are identical and parallel.

7. The cold plate of any one of claims 1-6, wherein the third channel is identical, but oppositely oriented, to the first channel.

8. The cold plate of any one of claims 1-7, wherein the channels are configured to minimize pressure drop of a refrigerant as the refrigerant changes phase from liquid to vapor flowing from the inlet ports to the outlet ports.

9. The cold plate of any one of claims 1-8, wherein the first and second inlet ports are fluidically coupled by a first manifold adjacent to the bottom of the first end of the cold plate and wherein the first and second outlet ports are fluidically coupled by a second manifold adjacent to the top of the second end of the cold plate; or optionally wherein the first and second outlet ports are fluidically coupled by a second manifold adjacent to the second end of the cold plate.

10. The cold plate of claim 9, wherein the third inlet port is fluidically coupled to a third manifold adjacent to the bottom of the second end of the cold plate, below the second manifold, and wherein the third outlet port is fluidically coupled to a fourth manifold adjacent to the top of the first end of the cold plate, above the first manifold; and/or optionally
wherein the cold plate is configured to receive refrigerant, in a liquid phase, into both the first and second ends; and wherein the cold plate is configured to transmit the refrigerant, in a vapor phase, from both the first and second ends; and/or optionally further comprising
a fourth inlet port positioned along the second end adjacent to the bottom;
a fourth outlet port positioned along the first end adjacent to the top, wherein the fourth outlet port is of greater height and width than the fourth inlet port; and
a fourth channel running between the fourth inlet port and the fourth outlet port, identical and parallel to the third channel, the fourth channel located adjacent to the second channel.

11. The cold plate of any one of claims 1-10, wherein the second channel is different from the first channel.

12. An assembly comprising:
a first cold plate having a first end, a second end opposite the first end, and a plurality of channels therein, the first cold plate comprising:
first and second inlet ports positioned along the first end;
a third inlet port positioned along the second end;
first and second outlet ports positioned along the second end, wherein the first and second outlet ports are of greater height and width than the first and second inlet ports;
a third outlet port positioned along the first end, wherein the third outlet port is of greater height and width than the third inlet port;
a first channel running between the first inlet port and the first outlet port;
a second channel running between the second inlet port and the second outlet port; and
a third channel running between the third inlet port and the third outlet port, the third channel located at least partially between the first and second channels; and
a second cold plate having a third end, a fourth end opposite the third end, and a plurality of channels therein, the second cold plate comprising:
fourth and fifth inlet ports positioned along the third end;
a sixth inlet port positioned along the fourth end;
fourth and fifth outlet ports positioned along the fourth end, wherein the fourth and fifth outlet ports are of greater height and width than the fourth and fifth inlet ports;
a sixth outlet port positioned along the third end, wherein the sixth outlet port is of greater height and width than the sixth inlet port;
a fourth channel running between the fourth inlet port and the fourth outlet port;
a fifth channel running between the fifth inlet port and the fifth outlet port; and
a sixth channel running between the sixth inlet port and the sixth outlet port, the sixth channel located at least partially between the fourth and fifth channels;
wherein the first and second cold plates are coupled to each other, such that the inlet ports of the first cold plate are coupled to the outlet ports of the second cold plate.

13. The assembly of claim 12, wherein a first channel wall, between the first channel and the third channel, is thicker than a second channel wall, between the second channel and the third channel.

14. The cold plate of claim 7, wherein the third inlet port is fluidically coupled to a third manifold adjacent to the second end of the cold plate, meshed with the second manifold, and wherein the third outlet port is fluidically coupled to a fourth manifold adjacent to the first end of the cold plate, meshed with the first manifold.

15. The cold plate of claim 3, further comprising a fourth channel running between a fourth inlet port, positioned along the second end, and a fourth outlet port, positioned along the first end; wherein the fourth channel is located adjacent the second channel; and wherein a third channel wall, between the second channel and the fourth channel, is thicker than the second channel wall.
